# EUROPÄISCHE PATENTSCHRIFT

(11) **EP 4 108 053 B1**
(45) Veröffentlichungstag und Bekanntmachung des Hinweises auf die Patenterteilung: **15.10.2025**
(21) Anmeldenummer: 21705872.6
(22) Anmeldetag: 03.02.2021
(51) Int. Cl.: H05K 7/20, H05K 7/14

(54) **LEISTUNGSELEKTRONISCHE EINRICHTUNG SOWIE LEISTUNGSELEKTRONISCHES FUNKTIONSSYSTEM**
POWER ELECTRONICS DEVICE AND POWER ELECTRONICS FUNCTIONAL SYSTEM
DISPOSITIF D'ÉLECTRONIQUE DE PUISSANCE ET SYSTÈME FONCTIONNEL D'ÉLECTRONIQUE DE PUISSANCE

(30) Priorität: 19.02.2020 DE 102020104336
(43) Veröffentlichungstag der Anmeldung: 28.12.2022
(73) Patentinhaber: Schaeffler Technologies AG & Co. KG, 91074 Herzogenaurach (DE)
(72) Erfinder: AN, Bao Ngoc, 76131 Karlsruhe (DE); HUMBERT, Andreas, 77833 Ottersweier (DE); KROITZSCH, Jens, 67160 Wissembourg (FR)
(86) Internationale Anmeldenummer: PCT/DE2021/100102
(87) Internationale Veröffentlichungsnummer: WO 2021/164814

(56) Entgegenhaltungen:
- JP-A- 2013 179 104
- US-A1- 2009 033 410
- US-B1- 10 149 413

## Beschreibung

Die vorliegende Erfindung betrifft eine leistungselektronische Einrichtung sowie ein leistungselektronisches Funktionssystem, die in thermisch sowie energetisch optimierter Weise eine Kühlung eines Leistungshalbleiters gewährleisten.

Die leistungselektronische Einrichtung sowie das leistungselektronische Funktionssystem können im Bereich der Leistungselektronik bzw. der Aufbau-und Verbindungstechnik eingesetzt werden.

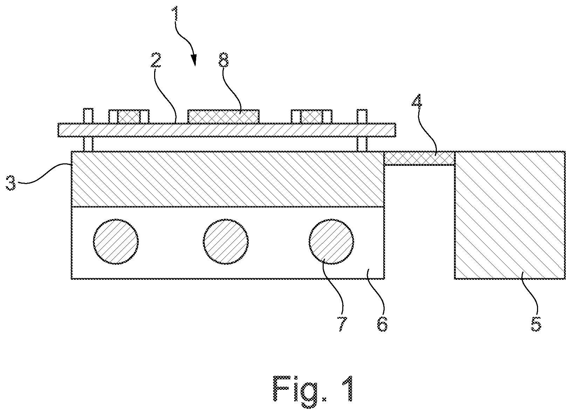

Konventionelle Leistungselektronik, wie beispielhaft in Figur 1 dargestellt, umfasst üblicherweise ein Leistungsmodul 3, welches auf einem auch als Coldplate bezeichneten sowie von einem Kühlmedium 7 durchströmten Kühlkörper 6 montiert ist und üblicherweise über eine Busbar 4 mit einem Zwischenkreiskondensator 5 verbunden ist.

Gatetreiber-Schaltungen und Steuerelektronik bzw. ein Chip 8 sind dabei üblicherweise auf einer von der Leistungselektronik umfassten Steuer-Leiterplatte 2 angeordnet.

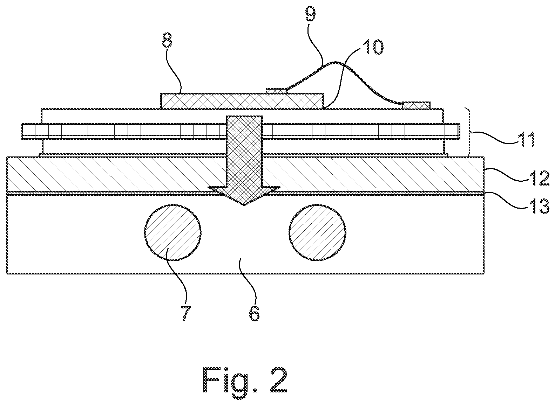

Der Aufbau eines herkömmlichen Leistungsmoduls 3 ist in vergrößerter Ansicht in Figur 2 dargestellt. Es ist ersichtlich, dass hier der Chip 8 über einen Bonddraht 9 und eine Lotschicht 10 mit einer aus einer Kupfer-Keramik-Kupferschicht realisierten elektrischen Verbindung DCB 11 an einen auch als Baseplate 12 bezeichneten Grundkörper angeschlossen ist. Wärmeleitpaste 13 erleichtert den Wärmetransport von der Baseplate 12 auf den Kühlkörper 6 und damit auf das Kühlmedium 7.

Weitere Ausgestaltungsformen von konventioneller Leistungselektronik und insbesondere deren Kühlungsaspekte werden unter Bezugnahme auf die folgenden Dokumente erläutert.

Die US 9,560,790 B2 offenbart ein Kühlsystem für ein Kraftfahrzeug. Das Kühlsystem umfasst einen Verdampfer, einen Kondensator, der stromabwärts des Verdampfers angeordnet ist, eine Pumpe, die stromabwärts des Kondensators angeordnet ist, und einen Zweiphasenkühler, der stromabwärts der Pumpe und in Reihe stromaufwärts des Verdampfers angeordnet ist. Der Zweiphasenkühler kann Wärmeenergie von einer Wärmeerzeugungsvorrichtung empfangen, um ein Arbeitsfluid vorzuwärmen, und das vorgewärmte Arbeitsfluid zum Verdampfer leiten. Die Wärmeerzeugungsvorrichtung kann eine Leistungselektronikvorrichtung sein, die thermisch mit dem Zweiphasenkühler gekoppelt ist.

Die US 9,363,930 B2 offenbart ein Kühlsystem mit einer Kühlplatte, die konfiguriert ist, mit einem flüssigen Kühlmittel kontaktiert zu werden und Dampfphasenkühlmittel abzugeben. Des Weiteren umfasst das Kühlsystem einen Wärmetauscher, der dazu eingerichtet ist, Wärme des dampfförmigen Kühlmittels auf flüssiges Kühlmittel zu übertragen.

Die US 5,455,458 offenbart eine Kühlungseinrichtung für einen Leistungshalbleiter, der zusammen mit einem Substrat in einem Gehäuse auf einer Wärmeextraktionsbasis angeordnet sind. Der Raum innerhalb des Gehäuses ist mit einem Phasenwechselmaterial gefüllt, das Wärme bei einer Übergangstemperatur unterhalb der kritischen Temperatur des Leistungshalbleiters aufnimmt, um Wärme während Spitzenlasten aufzunehmen. Drähte koppeln den Leistungshalbleiter thermisch mit dem Phasenwechselmaterial. Über ein Basiselement wird sowohl dem Halbleiterwafer als auch dem Phasenwechselmaterial Wärme entzogen.

Die US 2008/0266802 A1 offenbart eine Technik zum Kühlen von Verbindungspunkten in leistungselektronischen Schaltkreisen, wie zum Beispiel Verbindungspunkten, die durch Drahtbondverbindungen hergestellt werden. Ein Phasenwechsel-Wärmeverteiler ist an oder in der Nähe des Verbindungspunkts thermisch gekoppelt, und im Wärmeverteiler findet ein kontinuierlicher Phasenwechsel statt, um dem Verbindungspunkt während des Betriebs Wärme zu entziehen. Der Wärmeverteiler kann sich über einen Bereich erstrecken, der größer als der Verbindungspunkt ist, um die Kühlung zu verbessern und Wärme über einen größeren Bereich abzuleiten. Dabei ist vorgesehen, dass der Phasenwechsel unterhalb des zu kühlenden Bauteils bzw. des Chips angeordnet ist.

Die WO 2014/131589 A1 offenbart eine Kühlvorrichtung mit Phasenwechselspeichern für Umrichter zur Umrichterkühlung und Abfuhr von Wärme bei Verlustleistungsspitzen. Die Kühlvorrichtung umfasst eine zu kühlende Komponente mit variierenden Verlustleistungen, wobei die zu kühlende Komponente ein Umrichtermodul aufweist. Daran thermisch angekoppelt ist ein Kühlkörper mit Kühlrippen und ein Phasenwechselspeicher, wobei der Kühlkörper und der Phasenwechselspeicher über wenigstens ein Wärmerohr thermisch miteinander verbunden sind.

Bei den vorgestellten Kühlungseinrichtungen, die insbesondere zur Kühlung von leistungselektronischen Einrichtungen ausgestaltet sind, bestehen jedoch thermische Restriktionen dahingehend, dass insbesondere bei Spitzenlasten trotz umgebender Kühlflüssigkeit die vom Leistungshalbleiter generierte Wärme nicht oder in nicht ausreichend kurzer Zeit abgegeben werden kann.

Zur Überwindung dieses Nachteiles werden in herkömmlichen Ausführungsformen des Öfteren stark vergrößerte Wärmeübertragungsflächen realisiert. Dies führt jedoch zu einem deutlich erhöhten Bauraumbedarf, sodass damit ausgestattete leistungselektronische Funktionssysteme eine geringe Leistungsdichte aufweisen.

Zudem sind derartige Systeme hinsichtlich ihrer Leistung entsprechend nicht skalierbar. Des Weiteren weisen auf diesem Gebiet bekannte Systeme oftmals eine ungewollte, eine sogenannte parasitäre Induktivität auf, welche gegebenenfalls zu einer Beeinflussung der von der leistungselektronischen Funktionseinheit ausgegebenen Signale und/oder zu Spannungsüberschwingungen beim Schalten führt.

Aus der JP 2013 179104 A ist eine leistungselektronische Einrichtung gemäß dem Oberbegriff des Anspruchs 1 bekannt.

Aus der US 2009/033410 A1 sind Leistungshalbleiter bekannt, die über Bonddrähte mit einer Steuerungsleiterplatte verbunden sind.

Aus der US 10 149 413 B1 sind Leistungshalbleiter bekannt, die über einen flüssigkeitsgekühlten Kühlkörper mit eingebetteten Kühlkanälen mit einer Steuerungsleiterplatte verbunden.

Hiervon ausgehend liegt der vorliegenden Erfindung die Aufgabe zugrunde, eine leistungselektronische Einrichtung sowie ein leistungselektronisches Funktionssystem zur Verfügung zu stellen, die in thermisch sowie energetisch optimierter Weise eine Kühlung eines Leistungshalbleiters gewährleisten.

Diese Aufgabe wird durch die erfindungsgemäße leistungselektronische Einrichtung nach Anspruch 1 sowie durch das erfindungsgemäße leistungselektronische Funktionssystem nach Anspruch 9 gelöst. Vorteilhafte Ausführungsformen der erfindungsgemäßen leistungselektronischen Einrichtung sind in den Unteransprüchen 2 bis 8 angegeben.

Ergänzend wird erfindungsgemäß ein Kraftfahrzeug gemäß Anspruch 10 zur Verfügung gestellt, welches wenigstens eine erfindungsgemäße leistungselektronische Einrichtung oder ein erfindungsgemäßes leistungselektronisches Funktionssystem umfasst.

Die Merkmale der Ansprüche können in jeglicher technisch sinnvollen Art und Weise kombiniert werden, wobei hierzu auch die Erläuterungen aus der nachfolgenden Beschreibung sowie Merkmale aus den Figuren hinzugezogen werden können, die ergänzende Ausgestaltungen der Erfindung umfassen.

Die Erfindung betrifft eine leistungselektronische Einrichtung, welche wenigstens einen Leistungshalbleiter sowie eine mit dem Leistungshalbleiter steuerungstechnisch verbundene erste Leiterplatte umfasst.

Des Weiteren umfasst die leistungselektronische Einrichtung wenigstens einen Leadframe, der die steuerungstechnische Verbindung zwischen dem Leistungshalbleiter und der ersten Leiterplatte realisiert. Es ist erfindungsgemäß vorgesehen, dass der Leistungshalbleiter an wenigstens einen Kontaktierungsbereich des Leadframes derart angeschlossen ist, dass Wärme vom Leistungshalbleiter auf den Leadframe übertragbar ist und vom Leadframe von dem Leistungshalbleiter weg leitbar ist. Dabei umfasst die leistungselektronische Einrichtung des Weiteren ein Gehäuse, welches zumindest bereichsweise ein Flüssigkeits-Reservoir begrenzt, in welchem eine Kühlflüssigkeit aufgenommen ist oder aufnehmbar ist. Ein jeweiliger Leistungshalbleiter und ein jeweiliger Leadframe sind in dem Flüssigkeits-Reservoir angeordnet zwecks Übertragung von Wärme vom jeweiligen Leistungshalbleiter und/oder vom jeweiligen Leadframe auf die Kühlflüssigkeit.

Die vorliegende leistungselektronische Einrichtung ist eine Einrichtung der Leistungselektronik.

Der Leistungshalbleiter kann auch als Chip bezeichnet werden und hat die Funktion einer Schalteinrichtung. Eine vorteilhafterweise ebenfalls von der leistungselektronischen Einrichtung umfasste Steuereinheit, die in einer Ausführungsform aus einem Mikrocontroller und einem Gatetreiber gebildet sein kann, ist dazu eingerichtet, über die Leiterplatte dem Leistungshalbleiter Signale zuzuleiten. Von dem Leistungshalbleiter werden dann durch die Übermittlung von elektrischen Signalen Schaltprozesse an zu steuernden Komponenten, wie zum Beispiel an einem Elektromotor bzw. der entsprechenden Phase des Elektromotors, durchgeführt.

Insbesondere kann der Leistungshalbleiter mittels Sintern oder auch Löten mit dem Leadframe verbunden sein. Dabei kann der Leistungshalbleiter mit seiner sogenannten Chipunterseite mit dem Leadframe verbunden sein. Ebenso kann die Verbindung zwischen dem Leadframe und der Leiterplatte durch Sintern oder auch Löten realisiert sein.

Eine elektrische Energieversorgung kann dabei insbesondere über eine an die Leiterplatte angeschlossene Batterie realisiert sein, die über einen Zwischenkreiskondensator die Leiterplatte, den Leadframe und den Leistungshalbleiter bestromt.

Von der Batterie zur Verfügung gestellte elektrische Energie kann über die Leiterplatte und Hochstromkontakte zum Betrieb der Komponenten geleitet werden.

Die Steuereinheit selbst kann dabei außerhalb des vom Gehäuse umgrenzten Raums angeordnet sein, insbesondere auf der Leiterplatte und mit dieser steuerungstechnisch verbunden.

Der Zwischenkreiskondensator kann dabei ebenfalls auf der Leiterplatte angeordnet sein.

Der sogenannte Leadframe ist ein lötbarer metallischer Leitungsträger in Form eines Rahmens oder Kamms, der insbesondere zur Verwendung an Halbleiterchips ausgestaltet ist. Ein solcher Leadframe umfasst neben einem Kontaktierungsbereich zu Kontaktierung des Leistungshalbleiters eine Vielzahl von sich vom Kontaktierungsbereich erstreckenden Leitungselementen, die wiederum zur elektrischen Kontaktierung mit weiteren elektronischen Bauteilen, insbesondere mit der Leiterplatte, eingerichtet sind.

Der Leadframe erfüllt in der vorliegenden Erfindung somit die Funktion eines sogenannten "Heatspreaders", also eines Wärmeverteilers. Daneben wird auch über die Leiterplatte Wärme vom Leistungshalbleiter aufgenommen und von der Leiterplatte auf die Kühlflüssigkeit übertragen. Des weiteren dient der Leadframe der elektrischen Kontaktierung mit der Leiterplatte, insbesondere über seinen sogenannten "Drain"-Anschluss.

Die Leiterplatte ist insbesondere ein sogenanntes Hochstrom-PCB.

Das Gehäuse und somit auch die im Reservoir aufgenommene Kühlflüssigkeit umgeben den jeweiligen Leistungshalbleiter und den jeweiligen Leadframe.

Das Flüssigkeits-Reservoir bezeichnet hier also einen strömungstechnisch geschlossenen Raum, der zur Aufnahme der Kühlflüssigkeit dient.

Unabhängig von den möglichen Varianten hinsichtlich der Anzahl der Leistungshalbleiter sowie der Leadframes sind diese erfindungsgemäß in dem Flüssigkeits-Reservoir angeordnet.

Insbesondere ist vorgesehen, dass die Kühlflüssigkeit eine hinsichtlich der durch sie benetzten Bauteile inerte und/oder elektrisch isolierende Flüssigkeit ist.

Die Einheit aus Leiterplatte, Leadframe und mindestens Leistungshalbleiter kann auch als Halbbrückenmodul bezeichnet werden

Mit der erfindungsgemäßen leistungselektronischen Einrichtung lässt sich somit in optimaler Weise ein Leistungshalbleiter kühlen, sodass dieser mit einer entsprechend hohen elektrischen Leistung betrieben werden kann.

Der Aufbau der erfindungsgemäßen leistungselektronischen Einrichtung weist eine geringe parasitäre Induktivität auf. Des Weiteren sind nur geringe elektrische Widerstände zu überwinden. Zudem ist ersichtlich, dass für den Aufbau der erfindungsgemäßen leistungselektronischen Einrichtung keine kostenaufwändigen und/oder schweren Materialien wie Keramiken eingesetzt werden müssen.

In einer fortlaufenden Ausführungsform der leistungselektronischen Einrichtung ist vorgesehen, dass die leistungselektronische Einrichtung mindestens einen weiteren Leistungshalbleiter und wenigstens einen weiteren Leadframe umfasst, der die steuerungstechnische Verbindung zwischen dem weiteren Leistungshalbleiter und der ersten Leiterplatte realisiert, wobei der weitere Leistungshalbleiter an wenigstens einen Kontaktierungsbereich des weiteren Leadframes derart angeschlossen ist, dass Wärme vom weiteren Leistungshalbleiter auf den weiteren Leadframe übertragbar ist und vom weiteren Leadframe von dem weiteren Leistungshalbleiter weg leitbar ist, und wobei der weitere Leistungshalbleiter und der weitere Leadframe auf der dem Leistungshalbleiter und dem Leadframe gegenüberliegenden Seite der ersten Leiterplatte angeordnet sind.

Dabei ist die Erfindung nicht darauf eingeschränkt, dass lediglich Leistungshalbleiter und Leadframes an der Leiterplatte angeordnet sind, sondern es können auf beiden Seiten der Leiterplatte mehrere Leistungshalbleiter und Leadframes erfindungsgemäß angeordnet sein.

Es kann auch hier vorgesehen sein, dass der weitere Leistungshalbleiter mit einer der ersten Leiterplatte abgewandten Seite an den Kontaktierungsbereich des weiteren Leadframes angeschlossen ist.

In der Ausführungsform mit nur einem Leistungshalbleiter und einem Leadframe ist vorgesehen, dass das Gehäuse gegenüber der ersten Leiterplatte abgedichtet ist. Entsprechend dient hier die erste Leiterplatte zur Abgrenzung des Flüssigkeits-Reservoirs. Zwecks Abdichtung kann eine extra Dichtung zwischen dem Gehäuse und der jeweiligen Leiterplatte bzw. Leiterplatten-Seite angeordnet sein.

Zum Anschluss von Hochstromkontakten an der Leiterplatte können vertikale elektrische Verbindungen, sogenannte Vias, Verwendung finden, die selbst eine abdichtende Wirkung gegenüber den Hochstromkontakten und der Leiterplatte haben, sodass hier keine extra Abdichtung gegenüber der Kühlflüssigkeit vorgenommen werden muss.

Durch die Verwendung der Leiterplatte als Teil der Abdichtung des Flüssigkeit-Reservoirs lässt sich die elektrische Kontaktierung der Leistungshalbleiter nach außen hin über die Vias auf der Leiterplatte und über die Hochstromkontakte realisieren. Die Hochstromkontakte können dabei auf die Leiterplatte an den Via-Stellen gelötet sein. Daher ist eine Abdichtung der Hochstromkontakte nicht erforderlich.

Zwecks effizienter Wärmeabfuhr können Leitungselemente des jeweiligen Leadframes eine Gesamt-Wärmeübertragungsfläche Ag zur Übertragung von Wärme auf die Kühlflüssigkeit ausbilden, die in Bezug zu einer Anschlussfläche Ac des jeweiligen Leadframes, an der der jeweilige Leadframe den jeweiligen Leistungshalbleiter kontaktiert, im folgenden Verhältnis steht: Ag/Ac > 1.

Das bedeutet, dass die Gesamt-Wärmeübertragungsfläche, die durch die Leitungselemente des jeweiligen Leadframes realisiert wird, mindestens so groß ist wie die Kontaktierungsfläche. In günstiger Ausführungsform der leistungselektronischen Einrichtung ist die Gesamt-Wärmeübertragungsfläche deutlich größer, d.h. mindestens doppelt so groß wie die Kontaktierungsfläche.

Dieses Flächenverhältnis sorgt für eine optimale Verteilung der vom jeweiligen Leistungshalbleiter generierten Wärme und demzufolge für eine optimale Wärmeabfuhr und Kühlung des jeweiligen Leistungshalbleiters.

Es wird somit ein optimaler sogenannter Heatspreading- Effekt erzielt.

In einer vorteilhaften Ausführungsform ist vorgesehen, dass eine von Endbereichen der Leitungselemente des jeweiligen Leadframes umrissene Fläche auf der ersten Leiterplatte mindestens doppelt so groß ist wie die Fläche des jeweiligen Leistungshalbleiters, die der ersten Leiterplatte zugewandt ist.

Insbesondere kann die Ebene der Befestigung des jeweiligen Leadframes am jeweiligen Leistungshalbleiter zur ersten Leiterplatte einen Abstand aufweisen.

Dies ermöglicht den optimalen Wärmeübergang vom jeweiligen Leadframe an seine Umgebung bzw. auf die Kühlflüssigkeit aufgrund dessen, dass weite Bereiche seiner Leitungselemente vollständig von der Kühlflüssigkeit kontaktierbar sind.

Dies ist insbesondere auch dann realisiert, wenn der Leistungshalbleiter mit einer der ersten Leiterplatte abgewandten Seite am Leadframe befestigt ist.

Insbesondere kann vorgesehen sein, dass eine unmittelbare elektrische Verbindung zwischen dem Leistungshalbleiter und der Leiterplatte an der dem Leadframe gegenüberliegenden Seite des Leistungshalbleiters ausgebildet ist. Das bedeutet, dass der Leistungshalbleiter sowohl mittelbar über den Leadframe mit der Leiterplatte elektrisch gekoppelt ist, als auch unmittelbar mit der Leiterplatte elektrisch gekoppelt ist.

Dies wird insbesondere durch elektrisch leitfähige Schichten auf den beiden Kontaktierungsseiten des Leistungshalbleiters erreicht.

In einer weiteren vorteilhaften Ausführungsform ist vorgesehen, dass die erste Leiterplatte elektrisch mit einer zweiten Leiterplatte gekoppelt ist, wobei die erste Leiterplatte mit den daran angeordneten Leistungshalbleitern und Leadframes derart positioniert ist, dass der weitere Leadframe einen Abstand zur zweiten Leiterplatte aufweist.

Dies dient insbesondere dazu, dass der zweite Leadframe nicht abgedeckt ist, sondern von der Kühlflüssigkeit weitestgehend kontaktiert werden kann, zwecks effizienter Wärmeabfuhr.

In der Ausführungsform mit mindestens zwei Leistungshalbleitern und zwei Leadframes ist vorgesehen, dass das Gehäuse gegenüber der zweiten Leiterplatte abgedichtet ist, die elektrisch mit der ersten Leiterplatte verbunden ist. Entsprechend dient hier die zweite Leiterplatte zur Abgrenzung des Flüssigkeits-Reservoirs. Die elektrische Kopplung der zweiten Leiterplatte mit der ersten Leiterplatte erfolgt dabei insbesondere über weitere Hochstromkontakte.

Die zweite Leiterplatte umfasst neben der Funktion der Abgrenzung des Flüssigkeits-Reservoirs auch die Funktion der Kontaktierung nach außen, insbesondere an einen Zwischenkreiskondensator.

Zudem kann die leistungselektronische Einrichtung des Weiteren eine Kondensationseinheit umfassen, die dazu eingerichtet ist, unter Abkühlung verdampfter Kühlflüssigkeit diese zu kondensieren und wiederum zur Abkühlung des jeweiligen Leistungshalbleiters und/oder des jeweiligen Leadframes zur Verfügung zu stellen.

Dadurch wird erreicht, dass auch die Verdampfungswärme abgeführt werden kann. Die Kühlflüssigkeit wird somit in einem Wärmekreislauf geführt.

Dazu kann die Kondensationseinheit einen Aufnahmeraum zur Aufnahme eines Kühlmediums, insbesondere zur Durchströmung mit einem Kühlmedium, aufweisen, wobei die Kondensationseinheit dazu eingerichtet ist, Wärme von verdampfter Kühlflüssigkeit aufzunehmen und auf das Kühlmedium im Aufnahmeraum zu übertragen. Dadurch wird ein geschlossenes System einer hochperformanten Zweiphasenkühlung realisiert. Entsprechend ist die leistungselektronische Einrichtung in dieser Ausgestaltungsform mit einer Wärmetauscher-Funktion ausgeführt.

Weiterhin kann die Kondensationseinheit in Richtung auf das Flüssigkeits-Reservoir ausgebildete Vorsprünge, insbesondere Rippen, aufweisen, wobei sich der Aufnahmeraum zur Aufnahme des Kühlmediums zumindest bereichsweise in diese Vorsprünge hinein erstreckt. Durch diese insbesondere in Rippenform ausgebildeten Vorsprünge wird somit die Wärmeübertragungsfläche der Kondensationseinheit deutlich vergrößert. Aufgrund dessen, dass sich der Aufnahmeraum bis in die Vorsprünge hinein erstreckt, besteht eine optimale Wärmeübertragung von den Vorsprüngen auf das Kühlmedium in den Vorsprüngen, sodass in effizienter Weise durch das Kühlmedium die Kondensationseinheit abkühlbar ist und dementsprechend effizient eine Abkühlung der verdampften Kühlflüssigkeit und demzufolge eine Kondensation der Kühlflüssigkeit erreichbar ist.

Ein weiterer Aspekt der vorliegenden Erfindung ist ein leistungselektronisches Funktionssystem, welches mehrere erfindungsgemäße leistungselektronische Einrichtungen umfasst, wobei die leistungselektronischen Einrichtungen an Leitungen für unterschiedliche Spannungsphasen angeschlossen sind. Insbesondere kann das leistungselektronische Funktionssystem derart ausgeführt sein, dass mehrere erfindungsgemäße leistungselektronische Einrichtungen auf einem hochstromführenden Leitelement, wie zum Beispiel auf einem Multi-Layer Kupferblech montiert werden und zu einem mehrphasigen leistungselektronischen System zusammengeschaltet werden.

Zwischen den einzelnen leistungselektronischen Einrichtungen kann eine sehr niederinduktive, niederohmige Hochstromverbindung realisiert sein.

Insbesondere kann dabei eine jede erfindungsgemäße leistungselektronische Einrichtung mit einer Phase einer Wechselspannung gekoppelt sein. Aufgrund der möglichen Ausgestaltung der leistungselektronischen Einrichtungen als Module lässt sich das leistungselektronische Funktionssystem entsprechend einfach hinsichtlich des Ausgangsstroms und der Ausgangsleistung skalieren.

Über eine große Fläche des hochstromführenden Leitelements bzw. des Multi-Layer Kupferblechs kann weiterhin effizient Wärme an die Umgebung abgeführt werden.

Des Weiteren ist eine Abschirmung realisierbar zwecks Erreichung einer ausreichenden elektromagnetischen Verträglichkeit.

Ergänzt wird die vorliegende Erfindung durch ein Kraftfahrzeug, insbesondere zumindest teilweise elektromotorisch antreibbares Kraftfahrzeug, welches wenigstens eine erfindungsgemäße leistungselektronische Einrichtung und/ oder wenigstens ein erfindungsgemäßes leistungselektronisches Funktionssystem sowie einen Kühlmedium-Kreislauf, der strömungstechnisch mit der Kondensationseinheit der jeweiligen leistungselektronischen Einrichtung gekoppelt ist, umfasst.

Entsprechend kann ein in einem Kraftfahrzeug gegebenenfalls auch für weitere Zwecke genutztes Kühlmedium, wie zum Beispiel ein Wasser-Glykol-Gemisch, der erfindungsgemäßen leistungselektronischen Einrichtung zugeführt werden und somit die leistungselektronische Einrichtung in den Gesamt-Kühlkreislauf des Kraftfahrzeuges eingebunden werden.

Die oben beschriebene Erfindung wird nachfolgend vor dem betreffenden technischen Hintergrund unter Bezugnahme auf die zugehörigen Zeichnungen, welche bevorzugte Ausgestaltungen zeigen, detailliert erläutert. Die Erfindung wird durch die rein schematischen Zeichnungen in keiner Weise beschränkt, wobei anzumerken ist, dass die in den Zeichnungen gezeigten Ausführungsbeispiele nicht auf die dargestellten Maße eingeschränkt sind. Es ist dargestellt in
Figur 1: Leistungselektronik mit einem konventionellen Aufbau,
Figur 2: der Bereich des elektrischen Anschlusses des Chips gemäß der Ausführungsform nach Figur 1 in vergrößerter Ansicht,
Figur 3: eine erfindungsgemäße Leistungselektronik in Schnittansicht,
Figur 4: den Bereich des Anschlusses von Hochstromkontakten eines Hochstromkontaktes gemäß der in Figur 3 dargestellten Ausführungsform,
Figur 5: eine weitere Ausführungsform einer erfindungsgemäßen Leistungselektronik in Schnittansicht, und
Figur 6: ein erfindungsgemäßes leistungselektronisches Funktionssystem mit mehreren leistungselektronischen Einrichtungen gemäß der Erfindung.

Auf die Figuren 1 und 2 wurde bereits zur Erläuterung des Standes der Technik Bezug genommen.

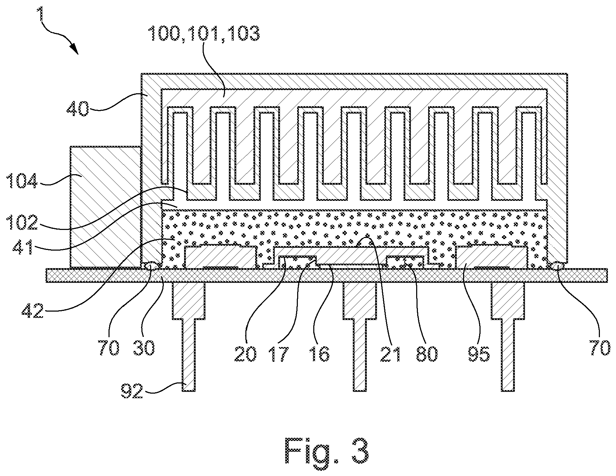

Figur 3 zeigt eine erste Ausführungsform einer erfindungsgemäßen leistungselektronischen Einrichtung 1.

Diese umfasst einen Leistungshalbleiter 16, der auch als Chip bezeichnet werden kann. Der Chip bzw. der Leistungshalbleiter 16 ist mit seiner Chipinterseite 17, die in der hier dargestellten Ausführungsform nach oben ausgerichtet ist, an einen Leadframe 20 elektrisch leitfähig angeschlossen. Es ist ersichtlich, dass der Kontaktierungsbereich 21 zwischen dem Leistungshalbleiter 16 und dem Leadframe 20 deutlich kleiner ist als die vom Leadframe 20 insgesamt ausgebildete Fläche, sodass vom Leistungshalbleiter 16 in den Leadframe 20 eingetragene Wärme vom Leadframe 20 über seine große Oberfläche verteilt werden kann. Der Leadframe 20 ist wiederum elektrisch mit einer ersten Leiterplatte 30 verbunden. Entsprechend wird vom Leadframe 20 auch Wärme auf die erste Leiterplatte 30 übertragen. Der Leistungshalbleiter 16 sowie der Leadframe 20 befinden sich innerhalb eines von einem Gehäuse 40 abgegrenzten Flüssigkeits-Reservoirs 41. In diesem Flüssigkeits-Reservoir 41 ist Kühlflüssigkeit 42 vorhanden, die den Leistungshalbleiter 16 sowie den Leadframe 20 vollständig umgeben. Entsprechend kann über die große Fläche des Leadframes 20 Wärme vom Leistungshalbleiter 16 an die Kühlflüssigkeit 42 übertragen werden und entsprechend effektiv der Leistungshalbleiter 16 gekühlt wird.

Die erste Leiterplatte 30 ist somit multifunktional ausgestaltet, da sie der Kontaktierung des Leistungshalbleiters 16 dient sowie der elektrischen Kontaktierung nach außen und gleichzeitig aber auch zur bereichsweisen Abgrenzung des Flüssigkeits-Reservoirs 41.

Die leistungselektronische Einrichtung umfasst des Weiteren eine Kondensationseinheit 100, die einen Aufnahmeraum 101 ausbildet, in der ein Kühlmedium 103 angeordnet ist. Zwecks Vergrößerung der Oberfläche der Kondensationseinheit 100 sind in Richtung auf die erste Leiterplatte 30 ausgebildete Vorsprünge 102 vorgesehen, die Bestandteile des Aufnahmeraums 101 sind und entsprechend mit Kühlmedium 103 gefüllt sind.

Kommt es temperaturbedingt zu einer Verdampfung der Kühlflüssigkeit 42, so gelangt diese in Dampfform an die Kondensationseinheit 100. Aufgrund dessen, dass diese durch das Kühlmedium 103 auf einem tiefen Temperaturniveau gehalten wird, erfolgt eine Kondensation der dampfförmigen Kühlflüssigkeit 42, sodass die verflüssigte Kühlflüssigkeit 42 wiederum von den Vorsprüngen 102 abtropft und dem Flüssigkeits-Reservoir 41 zugeführt wird, zwecks erneuter Kühlung des Leistungshalbleiters 16 bzw. des Leadframes 20. Das Kühlmedium 103 der Kondensationseinheit 100 kann dabei strömungstechnisch mit einem weiteren Kreislauf, wie zu Beispiel einem Kühlsystem eines Kraftfahrzeugs, verbunden sein, sodass es ebenfalls über einen hier nicht dargestellten Wärmetauscher kühlbar ist und erneut dem beschriebenen Kondensationszweck zuführbar ist.

Zum Anschluss der leistungselektronischen Einrichtung 1 an ein Gleichstromnetz umfasst diese in der hier dargestellten Ausführungsform des weiteren einen sogenannten DC-Link Kondensator 104.

In einer alternativen Ausführungsform kann der DC-Link-Kondensator 104 auch bei der Montage der leistungselektronischen Einrichtung 1 durch eine Pressverbindung am Gehäuse 40 montiert werden.

Auf der ersten Leiterplatte 30 ist elektrisch leitfähig zudem ein sogenannter Snubber-Kondensator 95 angeordnet zwecks Dämpfung von Spannungsspitzen.

Zwischen dem Leadframe 20 und der ersten Leiterplatte 30 besteht ein Abstand 80. Der Abstand 80 ist in der hier dargestellten Ausführungsform derart eingestellt, dass der Leistungshalbleiter 16 mit seiner dem Leadframe 20 abgewandten Seite und demzufolge mit seiner Oberseite auf der ersten Leiterplatte 30 aufliegt und diese elektrisch leitfähig kontaktiert. Derart kann unmittelbar Wärme vom Leistungshalbleiter 16 auf die erste Leiterplatte 30 übertragen werden.

Zwischen dem Gehäuse 70 und der ersten Leiterplatte 30 ist eine Dichtung 70 angeordnet. Die elektrischen Signale bzw. die elektrische Stromversorgung werden von Hochstromkontakten 92, die mit der ersten Leiterplatte 30 gekoppelt sind, übertragen bzw. realisiert.

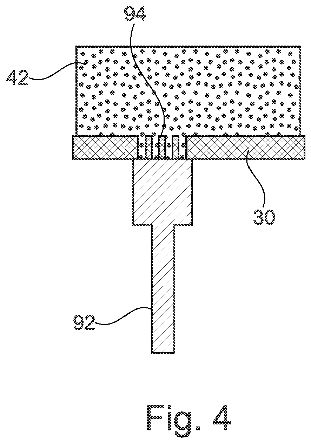

Dieser Anschluss ist in vergrößerter Ansicht in Figur 4 ersichtlich.

Es ist hier weiterhin erkennbar, dass ein jeweiliger Hochstromkontakt 92 über einen jeweiligen sogenannten Via 94 an die erste Leiterplatte 30 elektrisch leitfähig angeschlossen ist. Das Via 94 sorgt auch bei hin Durchführung durch die Leiterplatte 30 dabei gleichzeitig für eine Fluid-Abdichtung gegenüber der Kühlflüssigkeit 42.

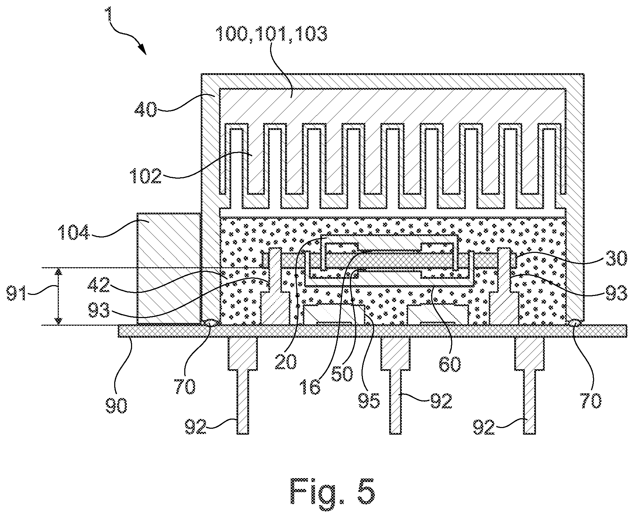

In Figur 5 ist eine weitere Ausführungsform der erfindungsgemäßen leistungselektronischen Einrichtung 1 dargestellt.

Diese unterscheidet sich von der in Figur 3 dargestellten Ausführungsform im Wesentlichen darin, dass auf der dem Leistungshalbleiter 16 und dem Leadframe 20 gegenüberliegenden Seite der ersten Leiterplatte 30 ein weiterer Leistungshalbleiter 50 sowie ein weiterer Leadframe 60 angeordnet sind. Der weitere Leistungshalbleiter 50 und der weitere Leadframe 60 sind dabei ebenso wie der Leistungshalbleiter 16 und der Leadframe 20 vollständig von der Kühlflüssigkeit 42 umgeben. Dafür sorgt ein Abstand 91 der ersten Leiterplatte 30 zur einer zweiten Leiterplatte 90, die zusammen mit dem Gehäuse 40 das Flüssigkeits-Reservoir 41 begrenzt.

Die Verbindung zwischen der ersten Leiterplatte 30 und der zweiten Leiterplatte 90 ist hier über weitere Hochstromkontakte 93 realisiert. Wie auch in der in Figur 3 dargestellten ersten Ausführungsform erfolgt der elektrische Anschluss der leistungselektronischen Einrichtung 1 über Hochstromkontakte 92, die aber in der hier dargestellten Ausführungsform an die zweite Leiterplatte 90 angeschlossen sind.

Die in Figur 5 dargestellte Ausführungsform umfasst somit den Vorteil, dass gleichzeitig zwei Leistungshalbleiter 16,50 sehr bauraumeffizient von einer Kühlflüssigkeit 42 kühlbar sind, die an einer gemeinsamen Kondensationseinheit 100 kondensiert.

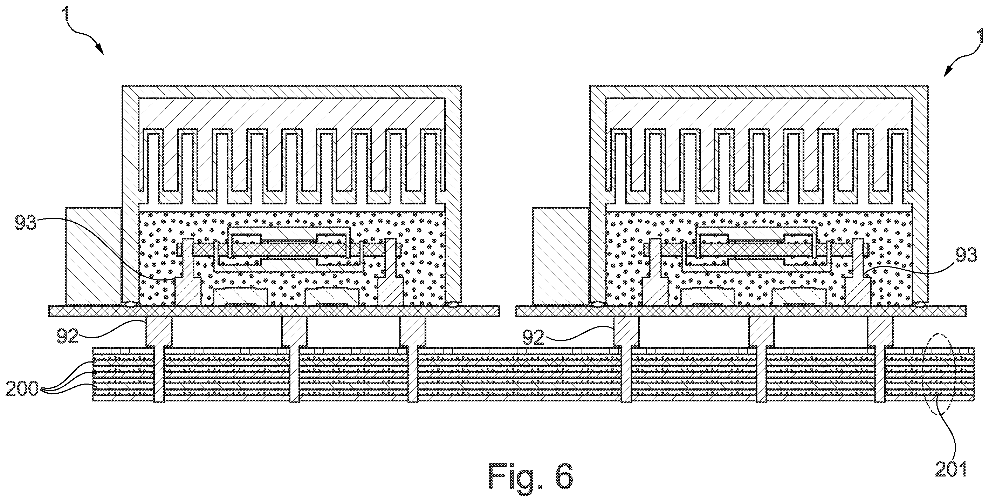

Figur 6 zeigt ein erfindungsgemäßes leistungselektronisches Funktionssystem, welches mehrere erfindungsgemäße leistungselektronische Einrichtungen 1 umfasst.

Die leistungselektronischen Einrichtungen 1 sind dabei mit den Hochstromkontakten 92 an stromführende Leitungen 200, die insbesondere Kupferblechlagen sein können über welche ebenfalls Wärme abführbar sind, angeschlossen. An den Ausgang der leistungselektronischen Funktionseinheit wird beispielsweise je eine Phase eines Drehstrommotors angeschlossen, hier am AC-Anschluss. An einem bei einem elektrischen Antriebssystem üblichen 3-phasigen Motor werden daher leistungselektronische Funktionseinheiten angeschlossen.

Die leistungselektronische Einrichtung sowie das leistungselektronische Funktionssystem ermöglichen in thermisch sowie energetisch optimierter Weise eine Kühlung eines Leistungshalbleiters, sodass dieser für eine hohe Leistung ausgelegt werden kann.

### Bezugszeichenliste

- 1: Leistungselektronische Einrichtung
- 2: Steuer-Leiterplatte
- 3: Leistungsmodul
- 4: Busbar
- 5: Zwischenkreiskondensator
- 6: Kühlkörper
- 7: Kühlmedium
- 8: Chip
- 9: Bonddraht
- 10: Lotschicht
- 11: DCB
- 12: Baseplate
- 13: Wärmeleitpaste
- 16: Leistungshalbleiter
- 17: Chipunterseite
- 20: Leadframe
- 21: Kontaktierungsbereich
- 30: erste Leiterplatte
- 40: Gehäuse
- 41: Flüssigkeits-Reservoir
- 42: Kühlflüssigkeit
- 50: weiterer Leistungshalbleiter
- 60: weiterer Leadframe
- 70: Dichtung
- 80: Abstand
- 90: zweite Leiterplatte
- 91: Abstand der ersten Leiterplatte zur zweiten Leiterplatte
- 92: Hochstromkontakt
- 93: weiterer Hochstromkontakt
- 94: Via
- 95: Snubber-Kondensator
- 100: Kondensationseinheit
- 101: Aufnahmeraum
- 102: Vorsprung
- 103: Kühlmedium
- 104: DC-Link Kondensator
- 200: Stromführende Leitungen/Schichten
- 201: AC-Phasenausgang

## Patentansprüche

1. Leistungselektronische Einrichtung (1), umfassend wenigstens einen Leistungshalbleiter (16) sowie eine mit dem Leistungshalbleiter (16) steuerungstechnisch verbundene erste Leiterplatte (30), wobei die leistungselektronische Einrichtung (1) des Weiteren wenigstens einen Leadframe (20) umfasst, der die steuerungstechnische Verbindung zwischen dem Leistungshalbleiter (16) und der ersten Leiterplatte (30) realisiert,
**dadurch gekennzeichnet, dass**
der Leistungshalbleiter (16) an wenigstens einen Kontaktierungsbereich (21) des Leadframes (20) derart angeschlossen ist, dass Wärme vom Leistungshalbleiter (16) auf den Leadframe (20) übertragbar ist und vom Leadframe (20) von dem Leistungshalbleiter (16) weg leitbar ist,
die leistungselektronische Einrichtung (1) des Weiteren ein Gehäuse (40) umfasst, welches zumindest bereichsweise ein Flüssigkeits-Reservoir (41) begrenzt, in welchem eine Kühlflüssigkeit (42) aufgenommen ist oder aufnehmbar ist, und
ein jeweiliger Leistungshalbleiter (16) und ein jeweiliger Leadframe (20) in dem Flüssigkeits-Reservoir (41) angeordnet sind zwecks Übertragung von Wärme vom jeweiligen Leistungshalbleiter (16) und/oder vom jeweiligen Leadframe (20) auf die Kühlflüssigkeit (42).

2. Leistungselektronische Einrichtung nach Anspruch 1, **dadurch gekennzeichnet, dass**
die leistungselektronische Einrichtung (1) einen weiteren Leistungshalbleiter (50) und wenigstens einen weiteren Leadframe (60) umfasst, der die steuerungstechnische Verbindung zwischen dem weiteren Leistungshalbleiter (50) und der ersten Leiterplatte (30) realisiert,
der weitere Leistungshalbleiter (50) an wenigstens einen Kontaktierungsbereich des weiteren Leadframes (60) derart angeschlossen ist, dass Wärme vom weiteren Leistungshalbleiter (50) auf den weiteren Leadframe (60) übertragbar ist und vom weiteren Leadframe (60) von dem weiteren Leistungshalbleiter (50) weg leitbar ist, und
der weitere Leistungshalbleiter (50) und der weitere Leadframe (60) auf der dem Leistungshalbleiter (16) und dem Leadframe (20) gegenüberliegenden Seite der ersten Leiterplatte (30) angeordnet sind.

3. Leistungselektronische Einrichtung nach Anspruch 2, **dadurch gekennzeichnet, dass** die erste Leiterplatte (30) elektrisch mit einer zweiten Leiterplatte (90) gekoppelt ist, wobei die erste Leiterplatte (30) mit den daran angeordneten Leistungshalbleitern (16,50) und Leadframes (20,60) derart positioniert ist, dass der weitere Leadframe (60) einen Abstand zur zweiten Leiterplatte (90) aufweist.

4. Leistungselektronische Einrichtung nach einem der Ansprüche 1 bis 3, **dadurch gekennzeichnet, dass** Leitungselemente des jeweiligen Leadframes (20, 60) eine Gesamt-Wärmeübertragungsfläche Ag zur Übertragung von Wärme auf die Kühlflüssigkeit (42) ausbilden, die in Bezug zu einer Anschlussfläche Ac des jeweiligen Leadframes (20,60), an der der jeweilige Leadframe (20,60) den jeweiligen Leistungshalbleiter (16,50) kontaktiert, im folgenden Verhältnis steht: Ag/Ac > 1.

5. Leistungselektronische Einrichtung nach einem der Ansprüche 1 bis 4, **dadurch gekennzeichnet, dass** die Ebene der Befestigung des jeweiligen Leadframes (20,60) am jeweiligen Leistungshalbleiter (16,50) zur ersten Leiterplatte (30) einen Abstand (80) aufweist.

6. Leistungselektronische Einrichtung nach einem der Ansprüche 1 bis 5, **dadurch gekennzeichnet, dass** die leistungselektronische Einrichtung (1) des Weiteren eine Kondensationseinheit (100) umfasst, die dazu eingerichtet ist, unter Abkühlung verdampfter Kühlflüssigkeit (42) diese zu kondensieren und wiederum zur Abkühlung des jeweiligen Leistungshalbleiters (16,50) und/oder des jeweiligen Leadframes (20,60) zur Verfügung zu stellen.

7. Leistungselektronische Einrichtung nach Anspruch 6, **dadurch gekennzeichnet, dass**
die Kondensationseinheit (100) einen Aufnahmeraum (101) zur Aufnahme eines Kühlmediums (103), insbesondere zur Durchströmung mit einem Kühlmedium (103), aufweist, und
die Kondensationseinheit (100) dazu eingerichtet ist, Wärme von verdampfter Kühlflüssigkeit (42) aufzunehmen und auf das Kühlmedium (103) im Aufnahmeraum (101) zu übertragen.

8. Leistungselektronische Einrichtung nach Anspruch 7, **dadurch gekennzeichnet, dass**
die Kondensationseinheit (100) in Richtung auf das Flüssigkeits-Reservoir (41) ausgebildete Vorsprünge (102), insbesondere Rippen, aufweist, und
sich der Aufnahmeraum (101) zur Aufnahme des Kühlmediums (103) zumindest bereichsweise in diese Vorsprünge (102) hinein erstreckt.

9. Leistungselektronisches Funktionssystem, umfassend mehrere leistungselektronische Einrichtungen (1) gemäß einem der Ansprüche 1 bis 8, wobei die leistungselektronischen Einrichtungen (1) an Leitungen für unterschiedliche Spannungsphasen angeschlossen sind.

10. Kraftfahrzeug, insbesondere zumindest teilweise elektromotorisch antreibbares Kraftfahrzeug, umfassend
eine leistungselektronische Einrichtung (1) gemäß einem der Ansprüche 1 bis 8 oder ein leistungselektronisches Funktionssystem gemäß Anspruch 9, und
einen Kühlmedium-Kreislauf, der strömungstechnisch mit der Kondensationseinheit (100) der jeweiligen leistungselektronischen Einrichtung (1) gekoppelt ist.

## Claims

1. A power electronics device (1) comprising at least one power semiconductor (16) and a first printed circuit board (30) connected to the power semiconductor (16) for control purposes, wherein the power electronics device (1) further comprises at least one lead frame (20) which provides the control connection between the power semiconductor (16) and the first printed circuit board (30),
**characterised in that**
the power semiconductor (16) is connected to at least one contacting region (21) of the lead frame (20) in such a way that heat can be transferred from the power semiconductor (16) to the lead frame (20) and can be conducted away from the power semiconductor (16) by the lead frame (20),
the power electronics device (1) further comprises a housing (40), which at least in regions delimits a liquid reservoir (41) in which a cooling liquid (42) is or can be received, and
a respective power semiconductor (16) and a respective lead frame (20) are arranged in the liquid reservoir (41) for the purpose of transferring heat from the respective power semiconductor (16) and/or from the respective lead frame (20) to the cooling liquid (42).

2. The power electronics device according to claim 1, **characterised in that**
the power electronics device (1) comprises a further power semiconductor (50) and at least one further lead frame (60), which provides the control connection between the further power semiconductor (50) and the first printed circuit board (30),
the further power semiconductor (50) is connected to at least one contacting region of the further lead frame (60) in such a way that heat can be transferred from the further power semiconductor (50) to the further lead frame (60) and can be conducted away from the further power semiconductor (50) by the further lead frame (60), and
the further power semiconductor (50) and the further lead frame (60) are arranged on the side of the first printed circuit board (30) opposite the power semiconductor (16) and the lead frame (20).

3. The power electronics device according to claim 2, **characterised in that** the first printed circuit board (30) is electrically coupled to a second printed circuit board (90), wherein the first printed circuit board (30) with the power semiconductors (16, 50) and lead frames (20, 60) arranged thereon is positioned such that the further lead frame (60) is at a distance from the second printed circuit board (90).

4. The power electronics device according to any one of claims 1 to 3, **characterised in that** line elements of the respective lead frame (20, 60) form a total heat transfer surface Ag for transferring heat to the cooling liquid (42), which has the following ratio with respect to a connection surface Ac of the respective lead frame (20, 60) at which the respective lead frame (20, 60) contacts the respective power semiconductor (16, 50): Ag/Ac > 1.

5. The power electronics device according to any one of claims 1 to 4, **characterised in that** the plane of mounting of the respective lead frame (20, 60) on the respective power semiconductor (16, 50) is at a distance (80) from the first printed circuit board (30).

6. The power electronics device according to any one of claims 1 to 5, **characterised in that** the power electronics device (1) further comprises a condensation unit (100) designed to condense evaporated cooling liquid (42) while cooling it and to make it available again for cooling the respective power semiconductor (16, 50) and/or the respective lead frame (20, 60).

7. The power electronics device according to claim 6, **characterised in that**
the condensation unit (100) has a receiving space (101) for receiving a cooling medium (103), in particular for a cooling medium (103) to flow through, and
the condensation unit (100) is designed to receive heat from evaporated cooling liquid (42) and transfer it to the cooling medium (103) in the receiving space (101).

8. The power electronics device according to claim 7, **characterised in that**
the condensation unit (100) has projections (102), in particular ribs, formed in the direction of the liquid reservoir (41), and
the receiving space (101) for receiving the cooling medium (103) extends at least in regions into these projections (102).

9. A power electronics functional system comprising a plurality of power electronics devices (1) according to any one of claims 1 to 8, wherein the power electronics devices (1) are connected to lines for different voltage phases.

10. A motor vehicle, in particular a motor vehicle that can be driven at least in part by an electric motor, comprising
a power electronics device (1) according to any one of claims 1 to 8 or a power electronics functional system according to claim 9, and
a cooling medium circuit that is fluidically coupled to the condensation unit (100) of the respective power electronics device (1).

## Revendications

1. Dispositif d'électronique de puissance (1), comprenant au moins un semi-conducteur de puissance (16) et une première carte de circuit imprimé (30) connectée au semi-conducteur de puissance (16) à des fins de commande, le dispositif d'électronique de puissance (1) comprenant en outre au moins une grille de connexion (20), qui réalise la connexion de commande entre le semi-conducteur de puissance (16) et la première carte de circuit imprimé (30),
**caractérisé en ce que**
le semi-conducteur de puissance (16) est connecté à au moins une zone de contact (21) de la grille de connexion (20) de telle sorte que la chaleur puisse être transférée du semi-conducteur de puissance (16) à la grille de connexion (20) et puisse être évacuée du semi-conducteur de puissance (16) par la grille de connexion (20),
le dispositif électronique de puissance (1) comprend en outre un boîtier (40), qui délimite au moins partiellement un réservoir de liquide (41), dans lequel un liquide de refroidissement (42) est ou peut être logé, et
un semi-conducteur de puissance (16) respectif et une grille de connexion (20) respective sont agencés dans le réservoir de liquide (41) afin de transférer la chaleur du semi-conducteur de puissance (16) respectif et/ou de la grille de connexion (20) respective au liquide de refroidissement (42).

2. Dispositif d'électronique de puissance selon la revendication 1, **caractérisé en ce que**
le dispositif électronique de puissance (1) comprend un autre semi-conducteur de puissance (50) et au moins une autre grille de connexion (60) qui réalise la connexion de commande entre l'autre semi-conducteur de puissance (50) et la première carte de circuit imprimé (30),
l'autre semi-conducteur de puissance (50) est connecté à au moins une zone de contact de l'autre grille de connexion (60) de telle sorte que la chaleur puisse être transférée de l'autre semi-conducteur de puissance (50) à l'autre grille de connexion (60) et puisse être évacuée de l'autre semi-conducteur de puissance (50) par l'autre grille de connexion (60), et
l'autre semi-conducteur de puissance (50) et l'autre grille de connexion (60) sont agencés sur le côté de la première carte de circuit imprimé (30) opposé au semi-conducteur de puissance (16) et à la grille de connexion (20).

3. Dispositif d'électronique de puissance selon la revendication 2, **caractérisé en ce que** la première carte de circuit imprimé (30) est couplée électriquement à une seconde carte de circuit imprimé (90), la première carte de circuit imprimé (30) sur laquelle sont agencés les semi-conducteurs de puissance (16, 50) et les grilles de connexion (20, 60) étant positionnée de telle sorte qu'une distance sépare l'autre grille de connexion (60) de la seconde carte de circuit imprimé (90).

4. Dispositif d'électronique de puissance selon l'une des revendications 1 à 3, **caractérisé en ce que** les éléments conducteurs de la grille de connexion (20, 60) respective forment une surface totale de transfert thermique Ag pour le transfert de chaleur vers le liquide de refroidissement (42), qui, par rapport à une surface de connexion Ac de la grille de connexion (20, 60) respective, au niveau de laquelle la grille de connexion (20, 60) respective est en contact avec le semi-conducteur de puissance (16, 50) respectif, présente le rapport suivant : Ag/Ac > 1.

5. Dispositif d'électronique de puissance selon l'une des revendications 1 à 4, **caractérisé en ce que** le plan de fixation de la grille de connexion (20, 60) respective sur le semi-conducteur de puissance (16, 50) respectif présente une distance (80) par rapport à la première carte de circuit imprimé (30).

6. Dispositif d'électronique de puissance selon l'une des revendications 1 à 5, **caractérisé en ce que** le dispositif d'électronique de puissance (1) comprend en outre une unité de condensation (100) qui est conçue pour condenser le liquide de refroidissement (42) évaporé tout en le refroidissant et pour le rendre à son tour disponible pour refroidir le semi-conducteur de puissance (16, 50) respectif et/ou la grille de connexion (20, 60) respective.

7. Dispositif d'électronique de puissance selon la revendication 6, **caractérisé en ce que**
l'unité de condensation (100) comporte un espace de réception (101) destiné à recevoir un agent de refroidissement (103), en particulier destiné à être traversé par un agent de refroidissement (103), et
l'unité de condensation (100) est conçue pour absorber la chaleur du liquide de refroidissement (42) évaporé et la transférer à l'agent de refroidissement (103) dans l'espace de réception (101).

8. Dispositif d'électronique de puissance selon la revendication 7, **caractérisé en ce que**
l'unité de condensation (100) comporte des saillies (102), en particulier des nervures, formées en direction du réservoir de liquide (41), et
l'espace de réception (101) destiné à recevoir l'agent de refroidissement (103) s'étend au moins partiellement dans ces saillies (102).

9. Système fonctionnel d'électronique de puissance comprenant plusieurs dispositifs d'électronique de puissance (1) selon l'une des revendications 1 à 8, dans lequel les dispositifs d'électronique de puissance (1) sont connectés à des lignes pour différentes phases de tension.

10. Véhicule automobile, en particulier véhicule automobile pouvant être entraîné au moins partiellement par un moteur électrique, comprenant
un dispositif d' électronique de puissance (1) selon l'une des revendications 1 à 8 ou un système fonctionnel d'électronique de puissance selon la revendication 9, et
un circuit d'agent de refroidissement qui est couplé fluidiquement à l'unité de condensation (100) du dispositif d'électronique de puissance (1) respectif.
